# EUROPÄISCHE PATENTSCHRIFT

(11) **EP 2 031 740 B1**
(45) Veröffentlichungstag und Bekanntmachung des Hinweises auf die Patenterteilung: **03.10.2018**
(21) Anmeldenummer: 08163153.3
(22) Anmeldetag: 28.08.2008
(51) Int. Cl.: H02K 11/00, H02K 5/22, H02K 29/08, H05K 1/18, H02K 5/08

(54) **Leiterplatte für bürstenlose Gleichstrommotore**
Circuit board for brush-less DC motors
Carte de circuit imprimé pour moteurs à courant continu sans balais

(30) Priorität: 31.08.2007 DE 102007041334
(43) Veröffentlichungstag der Anmeldung: 04.03.2009
(73) Patentinhaber: MELECS EWS GmbH & Co KG, 7011 Siegendorf (AT)
(72) Erfinder: Hellinger, Leopold, 3710, Ziersdorf (AT); Neumann, Gerhard, 3231, St. Margarethen (AT); Neumann, Philipp, 1200, Wien (AT); Schomann, Wolfgang, 1170, Wien (AT)
(74) Vertreter: Maier, Daniel Oliver

(56) Entgegenhaltungen:
- WO-A1-97/16883
- DE-A1-102005 021 726
- DE-A1-102005 046 759
- FR-A1- 2 852 460
- JP-A- 2002 026 481
- US-A- 4 961 343

## Beschreibung

Die Erfindung bezieht sich auf eine gattungsgemäße Leiterplatte mit Sensoren für die Erkennung der Position eines in einer Ausnehmung der Leiterplatte geführten Rotors eines bürstenlosen Gleichstrommotors, wie sie im Oberbegriff von Anspruch 1 festgelegt ist.

### Stand der Technik

Bürstenlose Gleichstrommachinen besitzen in der Regel Lagesensoren, die die Position des Rotors detektieren. Wie bei der bürstenbehafteten Gleichstrommaschine können auf diese Weise die Phasen in Abhängigkeit von der Lage des Rotors geschaltet werden. Die Positionsdetektion erfolgt dabei zumeist mittels magnetischer Hallsensoren. Gleichstrommaschinen dieser Art werden etwa in der Automobilindustrie für den Stellantrieb eines bewegten Bauteils verwendet.

Die Hallsensoren werden gemäß Stand der Technik mittels Durchsteckmontage, auch "through-hole technology" oder THT genannt, auf Leiterplatten befestigt, in denen eine Ausnehmung vorgesehen ist, in der der Rotor des bürstenlosen Gleichstrommotors geführt ist. Dabei werden im Gegensatz zur Oberflächenmontage, auch "surface-mounted technology" oder SMT genannt, die Hallsensoren sowie der Gleichstrommotor mittels Drahtanschlüssen, die bei der Montage über Kontaktlöcher durch die Leiterplatte gesteckt und anschließend durch spezielle THT-Lötprozesse, zumeist konventionelles Hand- oder Roboterlöten, mit einer Stromversorgung verbunden.

Konkret ist etwa bekannt, eine Leiterplatte mit drei bis fünf Hallsensoren mittels THT zu bestücken, wobei bei Verwendung von fünf Hallsensoren die Bestückung auf beiden Seiten der Leiterplatte erfolgt. Diese Sensoren liegen zumeist in TO92-Gehäusen vor. Da die Leiterplatten in der praktischen Anwendung zumeist starken Belastungen, wie etwa hohen Temperaturen oder Verschmutzung durch Motoröl oder Treibstoffe, ausgesetzt sind, werden sie abschließend mit Duroplasten umspritzt. Um das passgenaue Einlegen in ein Spritzgusswerkzeug zu ermöglichen und im Betrieb eine hohe Schaltgenauigkeit zu gewährleisten, ist eine genaue Positionierung der Hallsensoren vor dem Löten erforderlich. Dies wird mit Bestückmasken erreicht, wobei zur Stabilisierung während des Spritzvorgangs Kunststoffstützen verwendet werden. Die THT-Lötstellen werden im Anschluss mittels Lötroboter oder händisch gelötet.

Insbesondere bei Anwendungen in der Automobilindustrie werden Leiterplatten für kleine Motoren mit Größen von etwa 40 mm verwendet, sodass beengte Platzverhältnisse gegeben sind. Bei Einsatz der kleinsten TO92-Gehäuse mit etwa 1.5 mm Dicke verbleiben somit nur mehr etwa 0.3 mm für die Umspritzung, was in der Praxis zu unvollständiger Umspritzung führen kann.

Die Stromversorgung für den Gleichstrommotor verfolgt des Weiteren über Kupferstanzteile mit etwa 1 mm² Querschnitt. Diese Teile müssen händisch eingesteckt und gelötet werden. Schließlich ist für die Stromversorgung ein Anschlussstecker zu montieren, was ebenfalls nur durch Handbestückung erfolgen kann.

Leiterplatten der bekannten Art weisen somit mehrere Nachteile auf, insbesondere die Notwendigkeit einer händischen Bestückung für die Kupferstanzteile der Stromversorung und des Anschlusssteckers, sowie die zeitauwendigen Hand- bzw. Roboterlötvorgänge. Strukturelle Nachteile bestehen in den benötigten Bestückmasken, den separaten Kunststoffstützen für die Sensoren, die örtlich mitunter sehr dünne Umspritzung, sowie die erforderlichen Stanzgitter für die Stromzuführung. Diese Nachteile verursachen nicht nur erhöhte Produktionskosten, sondern auch Verminderungen der Qualität und der strukturellen Stabilität der Bauteile.

DE-A-102005021726 offenbart eine Leiterplatte nach dem Oberbegriff des Anspruchs 1.

### Darstellung der Erfindung

Es ist daher das Ziel der Erfindung, diese Nachteile zu vermeiden und qualitativ hochwertige Leiterplatten für bürstenlose Gleichstromotore zu verwirklichen, die überdies einfacher und daher kostengünstiger hergestellt werden können. Diese Ziele werden durch die Merkmale von Anspruch 1 erreicht.
Bei einer Leiterplatte mit Sensoren für die Erkennung der Position eines in einer Ausnehmung der Leiterplatte geführten Rotors eines bürstenlosen Gleichstrommotors, wobei die Sensoren im Umfangsbereich der Ausnehmung angeordnet sind, und die Leiterplatte eine Stromzuführung für die Stromversorgung der Sensoren und des Gleichstrommotors aufweist, ist dabei erfindungsgemäß vorgesehen, dass die Sensoren an vom Inneren der Ausnehmung in eine zur Leiterplatte senkrechten Lage aufgebogenen Flügel der Leiterplatte mittels lötfähiger Anschlussflächen befestigt sind. Es handelt sich somit um eine Oberflächenmontagetechnik ("surface-mounting technology", SMT), im Gegensatz zu der gemäß dem Stand der Technik zur Befestigung von Positionssensoren an Leiterplatten gebräuchlichen Durchsteckmontage ("through-hole technology", THT), da die Sensoren mittels lötfähiger Anschlussflächen direkt auf die Leiterplatte gelötet sind. Zur erforderlichen Positionierung der Sensoren vertikal zur Leiterplatte werden die Sensoren auf in das Innere der Ausnehmung abstehende Flügel der Leiterplatte angeordnet, wobei die Flügel in weiterer Folge nach dem Bestück- und Lötvorgang lediglich aufgebogen werden müssen. Dadurch können zeitaufwendige Arbeitsvorgänge, wie die Bestückung und das Hand-bzw. Roboterlöten, viel rascher durchgeführt werden.

Weitere vorteilhafte Merkmale der Erfindung sind den Unteransprüchen zu entnehmen.

So kann etwa vorgesehen sein, dass für die an einer Seite der Leiterplatte befindlichen Flügel ein entlang des Umfangbereiches der Ausnehmung verlaufender Stützrahmen vorgesehen ist. Ein auf diese Weise verlaufender Stützrahmen stützt aufgrund seiner Geometrie die auf einer Seite befindlichen Flügel wesentlich besser, als die im Stand der Technik vorgesehenen Kunststoffstützen für die Sensorhalterungen.

Gemäß einer weiteren vorteilhaften Ausführungsvariante der Erfindung ist es vorgesehen, dass die Stromzuführung durch einen von der Ebene der Leiterplatte in eine zur Leiterplatte senkrechten Lage aufgebogenen Bereich der Leiterplatte gebildet wird, in dem Leiterbahnen der Leiterplatte kontaktierbar sind. Daher erübrigt sich ein eigener Anschlusstecker, der nur händisch zu montiert wäre.

In einer weiteren vorteilhaften Ausführungsvariante der Erfindung ist vorgesehen, dass es sich bei den Sensoren um Hallsensoren handelt.

### Kurzbeschreibung der Zeichnungen

Im Anschluss erfolgt nun eine detaillierte Beschreibung der Erfindung anhand eines Ausführungsbeispiels. Dabei zeigt
Fig.1 eine erfindungsgemäße Leiterplatte in einem ersten Produktionsschritt, bei dem die Leiterplatte noch flach ist, und die Hallsensoren bereits angelötet wurden,
Fig. 2 eine erfindungsgemäße Leiterplatte in einem weiteren Produktionsschritt, bei dem die Flügel mit den Hallsensoren vom Inneren der Ausnehmung in eine zur Leiterplatte senkrechten Lage aufgebogen wurden, und zur Verwirklichung der Stromzuführung ein Bereich der Leiterplatte, in dem Leiterbahnen der Leiterplatte kontaktierbar sind, von der Ebene der Leiterplatte in eine zur Leiterplatte senkrechten Lage aufgebogen wurden, und
Fig. 3 eine teilweise Schnittansicht einer erfindungsgemäßen Leiterplatte in einem weiteren Produktionsschritt, bei dem die Leiterplatte umspritzt wurde.

### Ausführung der Erfindung

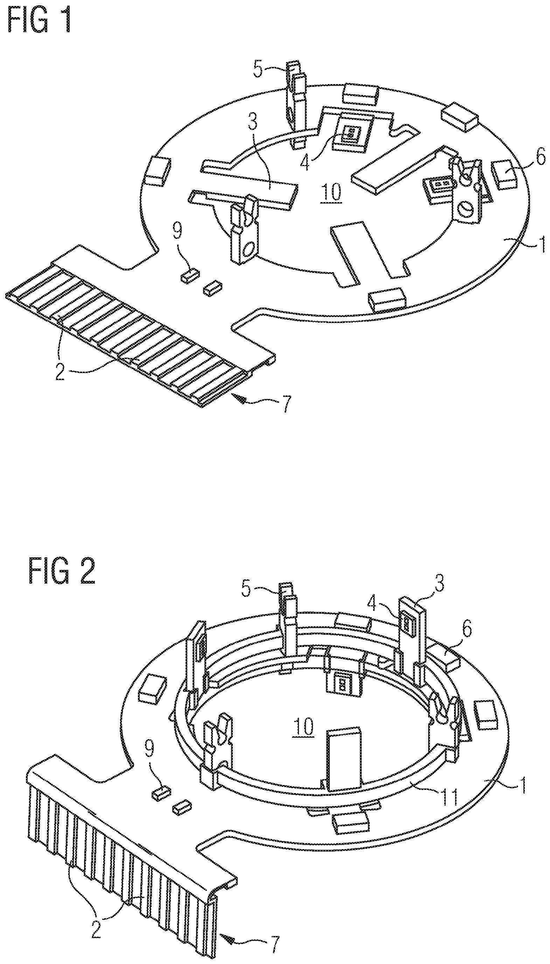

In der Fig.1 ist eine erfindungsgemäße Leiterplatte 1 in einem ersten Produktionsschritt dargestellt, bei dem die Leiterplatte 1 noch flach ist, und Flügel 3 der Leiterplatte 1 in das Innere einer Ausnehmung 10 der Leiterplatte 1 abstehen. In der Ausnehmung 10 der Leiterplatte 1 ist der Rotor eines bürstenlosen Gleichstrommotors (in der Fig. 1 nicht ersichtlich) geführt. Des Weiteren ist jeweils ein Hallsensor 4 auf jedem der Flügel 3 angeordnet, der jeweils mittels lötfähiger Anschlussflächen an der Leiterplatte 1 befestigt ist. Es handelt sich somit um ein so genanntes "SMD" (surface-mounted device), das mittels einer Lötpaste und anschließendem Reflowlöten an der Leiterplatte 1 befestigt wird. Als Leiterplatte 1 kann etwa eine 4-lagige Leiterplatte 1 mit zwei Lagen von etwa 20pm Kupferdicke und zwei Lagen von etwa 140µm Kupferdicke verwendet werden. Bei einer Leiterbahnbreite von etwa jeweils 3.5 mm kann der eingangs erwähnte Querschnitt von 1 mm² für die Stromzuführungen erzielt werden. Anstelle eines eigenen Anschlusssteckers werden in einem Bereich 7 der Leiterplatte 1, der im Produktionsschritt gemäß Fig. 1 ebenfalls noch in einer Ebene mit der restlichen Leiterplatte 1 liegt, die Leiterbahnen mit 140µm Kupferdicke als Anschlussleitungen 2 in Form der bekannten Flächen herkömmlicher Anschlusstecker ausgebildet, indem bei der Herstellung der Leiterplatte 1 dieser Bereich 7 so eingefräst wird, dass nur die Leiterbahnen mit 140µm Kupferdicke stehen bleiben. Zur besseren Stromverteilung kann dabei eine Verbindung der beiden übereinander liegenden Kupferbahnen mittels Durchkontaktierungen vorgesehen sein.

Des Weiteren sind in der Fig. 1 die Kontakte 5 für die Statorwicklungen des Gleichstormmotors ersichtlich, die ebenfalls an die Leiterplatte 1 als SMDs befestigt sind. Schließlich sind noch Kondensatoren 6 vorgesehen, die der Störsicherung der von den Hallsensoren 4 generierten Signale dienen, und zweckmäßiger Weise möglichst nahe an den Hallsensoren 4 anzuordnen sind. Es zeigt sich dabei bei der erfindungsgenäßen Lösung, dass die Kondensatoren 6 näher an den Hallsensoren 4 angeordnet werden können, als dies im Stand der Technik möglich ist. Als weitere Bauteile, die in Form von SMDs auf der Leiterplatte 1 befestigt sein können, sind in der Fig. 1 auch Kondesnatoren 9 dargestellt.

Die Fig. 2 zeigt die erfindungsgemäße Leiterplatte 1 gemäß Fig. 1 in einem weiteren Produktionsschritt, bei dem die Flügel 3 mit den Hallsensoren 4 vom Inneren der Ausnehmung 10 in eine zur Leiterplatte 1 senkrechten Lage aufgebogen wurden. Des Weiteren wurde zur Verwirklichung der Stromzuführung der Bereich 7 der Leiterplatte 1, in dem sich die Anschlussleitungen 2 befinden, von der Ebene der Leiterplatte 1 in eine zur Leiterplatte 1 senkrechten Lage aufgebogen. Die Fig. 2 zeigt dabei eine Ausführungsvariante, bei der drei Hallsensoren 4 nach oben abstehen, und zwei Hallsensoren 4 nach unten abstehen. Um die Flügel 3 in ihre senkrechte Lage biegen zu können, ist es zweckmäßig, im Zuge der Herstellung der Leiterplatte 1 den Verbindungsbereich zwischen Flügel 3 und Leiterplatte 1 einzufräsen. An dieser Fräskante können anschließend die Flügel 3 nach dem Bestücken und Löten der Hallsensoren 4 nach oben bzw. unten gebogen werden.

Des Weiteren ist für die an einer Seite der Leiterplatte 1 befindlichen Flügel 3 ein entlang des Umfangbereiches der Ausnehmung 10 verlaufender Stützrahmen 11 eingesetzt. Ein auf diese Weise verlaufender Stützrahmen 11 stützt aufgrund seiner Geometrie die auf einer Seite befindlichen Flügel 3 wesentlich besser, als die im Stand der Technik vorgesehenen Kunststoffstützen für die Sensorhalterungen.

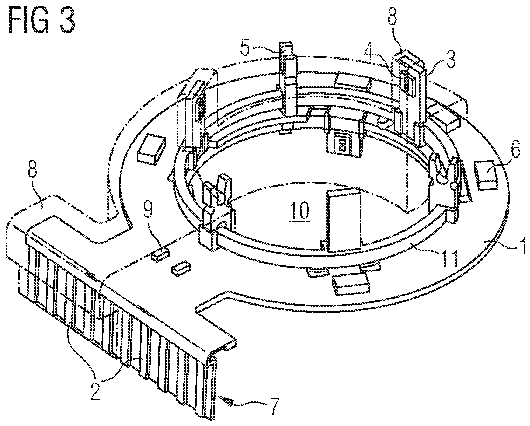

In der Fig. 3 ist eine teilweise Schnittansicht der erfindungsgemäßen Leiterplatte 1 gemäß der Fig. 1 und 2 in einem weiteren Produktionsschritt dargestellt, bei dem die Leiterplatte 1 mit einer Umspritzung 8, etwa eine Duroplastumspritzung, versehen wurde. Durch den erfindungsgemäßen Einsatz von Hallsensoren 4 in SMDbestückbaren Gehäusen, z.B. QFN-Gehäusen, wird die Verwendung sehr dünner Gehäuse ermöglicht, sodass die Dicke der Flügel 3 beispielsweise nur etwa 0.4 mm beträgt, und die Dicke der Umspritzung 8 daher beispielsweise bis zu 0.6-0.7 mm betragen kann. Dadurch wird eine sichere Ummantelung der elektronischen Bauteile ermöglicht.

Wie bereits erwähnt wurde, wird der Anschlussbereich für die Stromversorgung durch den aufgebogenen Bereich 7 der Leiterplatte 1 mit den Anschlussleitungen 2 gebildet. Im gezeigten Ausführungsbeispiel kann auf diese Weise etwa ein 10-poliger Anschlussbereich verwirklicht werden. Der Anschlussbereich kann dabei durch die Umspritzung 8 teilweise geschützt sein.

Die erfindungsgemäßen Leiterplatten 1 ermögichen somit eine qualitativ hochwertige Herstellung bürstenloser Gleichstromotore, die überdies einfacher und daher kostengünstiger hergestellt werden können.

## Patentansprüche

1. Leiterplatte (1) mit Sensoren (4) für die Erkennung der Position eines in einer Ausnehmung (10) der Leiterplatte (1) geführten Rotors eines bürstenlosen Gleichstrommotors, wobei die Sensoren (4) im Umfangsbereich der Ausnehmung (10) angeordnet sind, und die Leiterplatte (1) eine Stromzuführung für die Stromversorgung der Sensoren (4) und des Gleichstrommotors aufweist, **dadurch gekennze ichnet**, dass die Sensoren (4) an vom Inneren der Ausnehmung (10) in eine zur Leiterplatte (1) senkrechten Lage aufgebogenen Flügeln (3) der Leiterplatte (1) mittels lötfähiger Anschlussflächen befestigt sind.

2. Leiterplatte (1) nach Anspruch 1, **dadurch gekennzeichnet, dass** für die an einer Seite der Leiterplatte (1) befindlichen Flügel (3) ein entlang des Umfangbereiches der Ausnehmung (10) verlaufender Stützrahmen (11) vorgesehen ist.

3. Leiterplatte (1) nach Anspruch 1 oder 2, **dadurch gekennzeichnet, dass** die Stromzuführung durch einen von der Ebene der Leiterplatte (1) in eine zur Leiterplatte (1) senkrechten Lage aufgebogenen Bereich (7) der Leiterplatte (1) gebildet wird, in dem Leiterbahnen der Leiterplatte (1) als Anschlussleitungen (2) kontaktierbar sind.

4. Leiterplatte (1) nach einem der Ansprüche 1 bis 3, **dadurch gekennzeichnet, dass** es sich bei den Sensoren (4) um Hallsensoren handelt.

5. Gleichstrommotor mit einer Leiterplatte (1) nach einem der Ansprüche 1 bis 4.

## Claims

1. Circuit board (1) with sensors (4) for identifying the position of a rotor of a brushless DC motor guided in a recess (10) of the circuit board (1), wherein the sensors (4) are arranged in the peripheral region of the recess (10), and the circuit board (1) has a current supply for providing current to the sensors (4) and the DC motor, **characterised in that** the sensors (4) are fastened to blades (3) of the circuit board (1) bent out from inside the recess (10) into a position perpendicular to the circuit board (1) by means of solderable terminal regions.

2. Circuit board (1) according to claim 1, **characterised in that** a supporting frame (11) running along the peripheral region of the recess (10) is provided for the blades (3) located on one side of the circuit board (1).

3. Circuit board (1) according to claim 1 or 2, **characterised in that** the current supply is formed by a region (7) of the circuit board (1) bent out from the plane of the circuit board (1) into a position perpendicular to the circuit board (1), in which region (7) contact can be made with conductor paths of the circuit board (1) as connection lines (2).

4. Circuit board (1) according to one of claims 1 to 3, **characterised in that** the sensors (4) are Hall effect sensors.

5. DC motor with a circuit board (1) according to one of claims 1 to 4.

## Revendications

1. Carte de circuit imprimé (1) avec des capteurs (4) pour l'identification de la position d'un rotor de moteur à courant continu sans balais guidé dans un évidement (10) de la carte de circuit imprimé (1), les capteurs (4) étant agencés dans la zone périphérique de l'évidement (10) et la carte de circuit imprimé (1) comportant une alimentation en courant pour l'alimentation en courant des capteurs (4) et du moteur à courant continu, **caractérisée en ce que** les capteurs (4) sont fixés, au moyen de faces de raccordement aptes au brasage, à des ailettes (3) de la carte de circuit imprimé (1) repliées depuis l'intérieur de l'évidement (10) dans une position verticale par rapport à la carte de circuit imprimé (1).

2. Carte de circuit imprimé (1) selon la revendication 1, **caractérisée en ce qu'**est prévu, pour les ailettes (3) situées d'un côté de la carte de circuit imprimé (1), un cadre de support (11) qui longe la zone périphérique de l'évidement (10).

3. Carte de circuit imprimé (1) selon la revendication 1 ou 2, **caractérisée en ce que** l'alimentation en courant est constituée par une zone (7) de la carte de circuit imprimé (1) repliée depuis le plan de la carte de circuit imprimé (1) dans une position verticale par rapport à la carte de circuit imprimé (1), et dans laquelle des pistes conductrices de la carte de circuit imprimé (1) peuvent être contactées en tant que lignes de raccordement (2).

4. Carte de circuit imprimé (1) selon l'une des revendications 1 à 3, **caractérisée en ce que** les capteurs (4) sont des capteurs de Hall.

5. Moteur à courant continu comportant une carte de circuit imprimé (1) selon l'une des revendications 1 à 4.
